# EUROPEAN PATENT APPLICATION

(11) **EP 2 482 347 A2**
(43) Date of publication of application: **01.08.2012**
(21) Application number: 12152802.0
(22) Date of filing: 27.01.2012
(51) Int. Cl.: H01L 33/48

(54) **Method for packaging an LED emitting light omnidirectionally and an LED package**

(30) Priority: 31.01.2011 CN 201110035370
(71) Applicant: Cheng, Yung Pun, Kowloon, Hong Kong (CN)
(72) Inventor: Cheng, Yung Pun, Kowloon, Hong Kong (CN)
(74) Representative: Thomas, Nadine

(57) **Abstract**

The present invention discloses a method for packaging an LED emitting light omnidirectionally and an LED package. The present invention utilizes a transparent glue to bond LED chips (2) and electrodes (3) onto one or more transparent glass or organic films, and vertically or slantingly, with an angle between 0 and 60, fixes the transparent bracket having the LED chips (2) , electrodes (3) and welding wires (5) in a transparent vessel (7). When the diode power is on, the front face of the LED chips on the vertical transparent bracket (4) can emit light properly, while the rear face of the LED chips can emit brighter light via the transparent glass or organic film. The present invention makes it possible to demonstrate the brightest face of an LED, and thus improves LED light extraction.

## Description

### TECHNICAL FIELD

The present invention generally relates to the package technology of a light emitting diode (LED). In particular, the present invention relates to the package method utilizing a transparent glue to bond LED chips and electrodes onto a transparent glass or a transparent organic film, and an LED package fabricated with the same.

### BACKGROUND

An LED is a light emitting display device made of semiconductor material, which is able to convert electricity into light and has the advantages of low power consumption and high brightness, thus it is widely used as indicators and in display panels in various electronic circuits, household appliances, instruments, etc. Moreover, compared with common incandescent lamps, LEDs have small volume, low heating effect, low power consumption, long life, rapid reaction speed, and environmental amity, thus they are widely used for illumination.

Convential LEDs are fabricated by bonding a semiconductor sheet of 0.12 mm in thickness to a transparent silicon substrate, and such an LED light source has a front face and a rear face, wherein the rear face has a brightness over that of the front face by 20%, because the rear face is not printed with power supply circuirity.

In the conventional technologies, all LED chips are fixed on a planar plate positioned flatwise, electronic circuits for supplying power are printed on the LED chips, and various reflective technologies are conceived to reflect the light from the rear side of the chip back to the front side. However, the reflected light will be inevitably shielded by the printed circuits no matter how effective the reflective technology is, thus the prior package technology can only achieve 70% light extraction. In other words, the prior package technology can not demonstrate the brightest illumination face and has to utilize reflective technology to reflect the light from the bottom, which influences light extraction.

Chinese patent application No. 200810220159.9 (Publication No. CN101442098) discloses a high power LED, which comprises an LED chip vertically positioned in the reflective shade, wherein the positive electrode and the negative electrode of the LED chip are connected to the positive electrode bracket and the negative electrode bracket, respectively. Such a structure may improve the light extraction of the LED chip to some extent, but the brackets still shield a portion of light due to their comparatively large width, thus it fails to thoroughly solve the above-mentioned problem. In addition, in this prior art, the LED chip is fixed into the reflective shade by epoxy resin, thus the heat generated by the LED chip is difficult to dissipate, which may result in aging in the epoxy resin and in turn may reduce the light extraction of the LED.

Therefore, if both the front face and rear face of an LED can emit light properly, and the main light paths perpendicular to the front face and rear face are completely void of obstacles, the light extraction of the LED can be substantially improved. The present invention is directed to this problem and proposes a method for packaging an LED emitting light omnidirectionally.

### SUMMARY

According to one aspect of the present invention, there is provided a method for packaging an LED emitting light omnidirectionally, which comprises utilizing a transparent glue to bond at least one LED chip and at least two electrodes to a transparent bracket; utilizing welding wires to realize an electrical connection between the LED chip and the electrodes; and vertically fixing the transparent bracket with the LED chip, the electrodes and the welding wires in a transparent vessel.

In a further embodiment, the transparent bracket is vertically arranged on a susceptor in the transparent vessel. In this embodiment, the vertical arrangement of the transparent bracket can be realized by molding via the following steps: positioning the transparent bracket and power supply lines into a mold, wherein the electrodes of the transparent bracket cling to the power supply lines; and casting plastic material around a location where the electrodes and the power supply lines contact each other and curing the plastic material to form said susceptor. As an alternative, the vertical arrangement of the transparent bracket can also be realized by clipping via the following steps: fabricating power supply lines and the susceptor integrally, wherein one end of the power supply lines is embedded into the susceptor; forming a groove in the central part of the susceptor to expose the power supply lines, wherein said groove is sized to be able to tightly clip the transparent bracket having electrodes; and inserting the transparent bracket into the groove to form an electrical connection between the electrodes and the power supply lines.

In a further embodiment, the transparent bracket is vertically fixed by filling and curing a transparent material into the transparent vessel.

In a further embodiment, the transparent vessel can be filled with an insulating transparent liquid to facilitate the dissipation of the heat generated by LED chips. In addition, a fluorescent layer can be coated on the inner or outer surface of the transparent vessel to prevent the heat generated by the chips from directly conducting to the fluorescent material, which will avoid the decomposition and aging of the fluorescent material due to heating as well as the accompanying light attenuation and aberration.

In a further embodiment, the transparent bracket may be a transparent glass or transparent organic film of 0.4 mm to 5 mm in thickness, the welding wires can be gold or alloy conductive wires, and the transparent vessel can be a circular or rectangular vessel.

In a further embodiment, the transparent bracket can be a Y-shape assembly formed of three planar branches, and the angle between two neighboring planar branches preferably is 120°.

In a further embodiment, the transparent bracket can be a cross-shape assembly formed of four planar branches, and the angle between two neighboring planar branches preferably is 90°.

According to another aspect of the invention, there is provided an LED package emitting light omnidirectionally, which comprises a transparent bracket; at least one LED chip and at least two electrodes bonded to the transparent bracket via a transparent glue; welding wires for connecting the LED chip and the electrodes; and a transparent vessel; wherein the transparent bracket bonded with the LED chip, the electrodes and the welding wires is vertically fixed in the transparent vessel.

In a further embodiment, the LED package may further comprise a susceptor within the transparent vessel. In this embodiment, the transparent bracket may be vertically arranged on the susceptor via molding or clipping.

In a further embodiment, the transparent bracket may be vertically fixed by filling and curing a transparent material into the transparent vessel.

In a further embodiment, the LED package may further comprise an insulating transparent liquid filled in the transparent vessel, and/or a fluorescent layer coated on the inner face of the transparent vessel.

In a further embodiment, the transparent bracket may be a transparent glass or transparent film of 0.4 mm to 5 mm in thickness, the welding wires may be gold or alloy conductive wires, and the transparent vessel may be a circular or rectangular vessel.

In a further embodiment, the transparent bracket can be a Y-shape assembly formed of three planar branches, and the angle between two neighboring planar branches preferably is 120°. Further preferably, the same number of LED chips are positioned on the same side of each plane branch.

In a further embodiment, the transparent bracket can be a cross-shape assembly formed of four planar branches, and the angle between two neighboring planar branches preferably is 90°. Further preferably, the same number of LED chips are positioned on the same side of each plane branch.

The advantages of the present invention lie in utilizing a transparent glue to fix the LED chips to a vertical transparent bracket, and utilizing welding wires to electrically connect the chips and separate electrodes, wherein both the front face and rear face of the LED chips can emit light almost without shelter, therefore a maximum possible light extraction can be achieved.

### BRIEF DESCRIPTION OF THE DRAWINGS

Fig. 1 schematically shows a transparent bracket according to a first embodiment of the present invention.

Fig. 2 schematically shows a sectional view of the LED package according to the first embodiment of the present invention.

Fig. 3 schematically shows a perspective view of the LED package shown in Fig. 2 of the present invention, wherein part of the vessel is removed to show the internal structure.

Fig. 4A schematically shows a perspective view of the transparent bracket according to a second embodiment of the present invention.

Fig. 4B schematically shows a top view of the transparent bracket according to the second embodiment of the present invention.

Fig. 5A schematically shows a perspective view of the transparent bracket according to a third embodiment of the present invention.

Fig. 5B schematically shows a top view of the transparent bracket according to the third embodiment of the present invention.

### DETAILED DESCRIPTION OF THE PREFERRED EMBODIMENTS

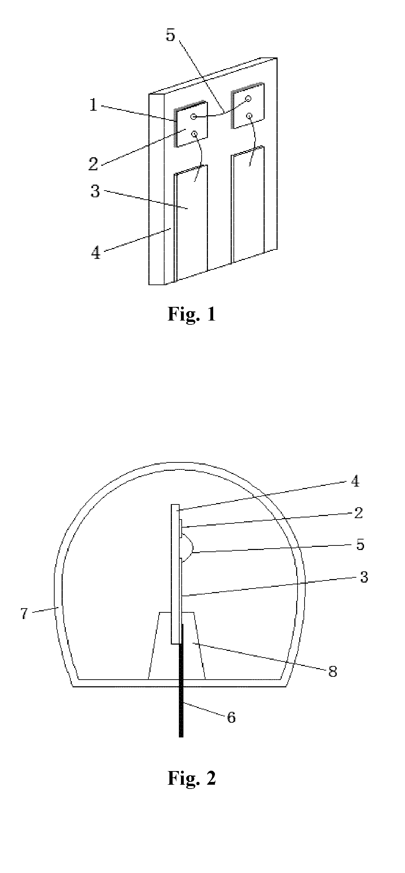

The present invention will be described in detail in connection with the drawings. First, reference is made to Fig. 1 which schematically shows a transparent bracket according to a first embodiment of the present invention. As shown in Fig. 1, the main part of transparent bracket 4 is one or more sheets of transparent material, such as a transparent glass or a transparent organic film of 0.4 mm to 5 mm in thickness. One or more LED chips 2 and one or more electrodes 3 are bonded onto one side of the transparent glass or transparent organic film via a transparent glue. Electrical connections between different chips and electrical connections between a chip and an electrode are realized by welding wires 5, and the welding wires are preferably conventional gold bonding wire, or other metal or alloy conductive wire. It is to be understood that, although two LED chips in series are shown in the figure, the present invention is not limited to this, for example, a single LED chip and two or more LED chips in series or parallel is also possible. With this implementation, i.e., the LED chip being connected to the electrode via welding wires rather than directly to the electrode, both faces of the LED chip can emit light without shade, therefore the light extraction can be nearly up to 100%.

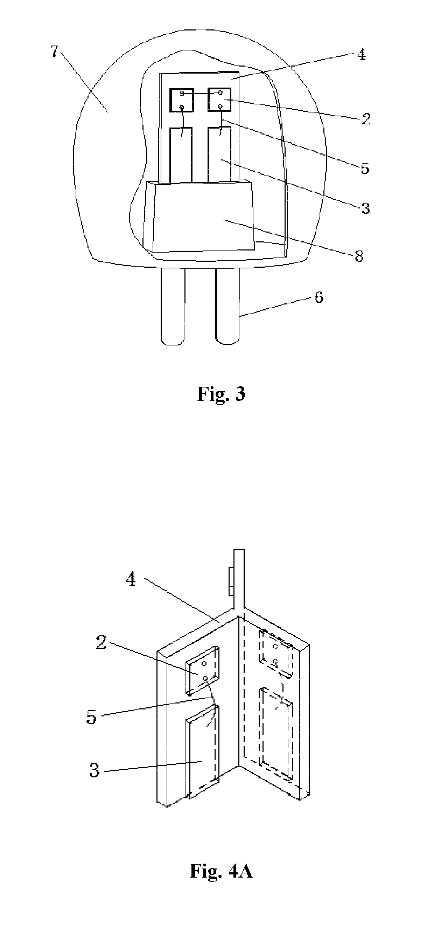

Figs. 2 and 3 illustrate one embodiment of the LED package according to the present invention. Different from the conventional horizontal arrangement, a transparent bracket 4 to which LED chips 2, positive/negative electrodes 3, and welding wires 5 are fixed is vertically arranged on a susceptor 8 within the transparent vessel 7, so as to make the positive/negative electrode 3 in close contact with positive/negative power supply lines 6. When the power is on, the front face of the LED chip on the vertical transparent bracket may emit light properly, and the rear face of the LED chip may also emit brighter light through the transparent glass or the transparent organic film. Thus, it is realized to eliminate the limitation of being unable to demonstrate the brightest face of a LED due to the power-supplying wires existing in the packaging, which was the technology of prior art, and thus improve LED light extraction.

The vertical arrangement of the transparent bracket can be realized by the following molding method: positioning the transparent bracket and power supply lines into a mold, wherein the electrodes of the transparent bracket cling to the power supply lines; and casting plastic material around the location where the electrodes and the power supply lines contact each other and curing the plastic material to form the susceptor, therefore a stable connection between the electrodes and the power supply lines is obtained. As an alternative, it is also possible to realize the vertical arrangement of the transparent bracket via clipping. For example, power supply lines and the susceptor can be fabricated integrally, wherein one end of the power supply lines is embedded into the susceptor. Then a groove is formed in the central part of the susceptor to expose the power supply lines, wherein the groove is sized to be able to tightly clip the transparent bracket having electrodes, so that when the transparent bracket is inserted into the groove, a stable electrical connection between the electrodes and the power supply lines will be achieved. In this way, the transparent bracket and the susceptor can be manufactured in batches and assembled rapidly.

It is to be noted that the former susceptor is not necessary for the present invention, and any manner to vertically fix the transparent bracket in the transparent vessel can be utilized. For example, the transparent bracket can be vertically fixed by filling and curing a transparent material into the transparent vessel.

As an alternative, the transparent vessel 7 can be filled with an insulating transparent liquid to expedite the dissipation of the heat generated by the LED chips. In addition, a fluorescent layer can be coated on the inner or outer surface of the transparent vessel 7 to form different color LEDs as required for the light emitted. By coating the fluorescent layer on the transparent vessel instead of on the LED chip directly, it is possible to prevent the generated heat from conducting to the fluorescent material, thus the decomposition and aging of fluorescent material due to heating can be avoided as well as avoiding the accompanying light attenuation and aberration.

While Fig. 3 shows a circular transparent vessel, it can be understood that a rectangular transparent vessel, or a transparent vessel in other shapes can also be utilized. In addition, the transparent vessel can be made of transparent plastic or glass.

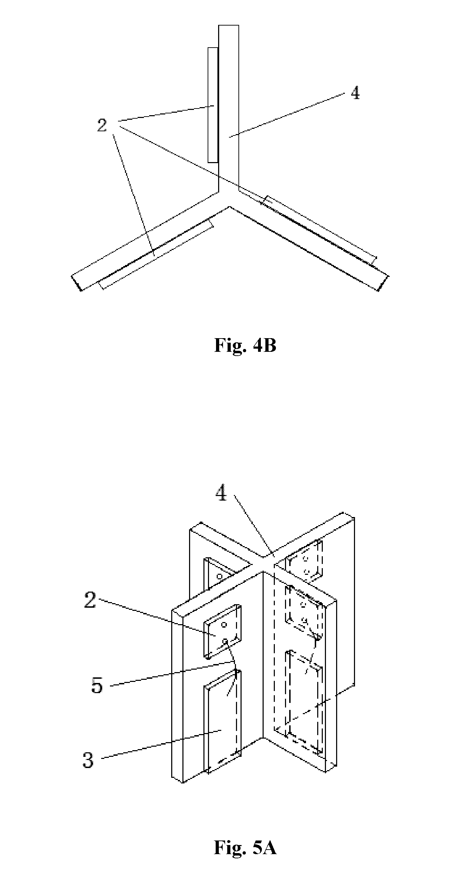

Figs. 4A and 4B schematically show the transparent bracket according to the second embodiment of the present invention. Different from the transparent bracket in the first embodiment, which is a single planar plate, the transparent bracket 4 of this embodiment comprises three planar branches forming a Y-shape. Preferably, the three planar branches are symmetrically distributed about the central axis, that is, the angle between two neighboring planar branches is preferably 120°, but other symmetric or asymmetric configurations are also possible.

As seen from the perspective view in Fig. 4A, one LED chip is bonded on each plane branch by a transparent glue, and two electrodes (i.e., the positive electrode and the negative electrode) are fixed on any two plane branches. For the purpose of simplification, the figure only shows the welding wires for electrical connection between the chip and the electrodes, the welding wires between chips in series are not shown. Of course, in order to weld conveniently, one LED chip and two electrodes (positive electrode and negative electrode) which connect to the positive terminal and negative terminal of the chip respectively can be positioned on each plane branch, thus in the susceptor (not shown), the positive and negative power supply lines are connected to three positive electrodes and three negative electrodes, respectively. Further, the transparent bracket shown in Fig. 1 can be used as one plane branch of the embodiment, that is, there are a plurality of LED chips in series on each plane branch.

As seen from the the top view of Fig. 4B, each LED chip is positioned on the same side of each plane branch, the light emitted from the front face of each chip and those from the rear face of another chip which travels through the transparent material may complement each other, and the main light path perpendicular to the chip surface will not be sheltered by the neighboring chips. Therefore, compared with bidirectional light emission in the first embodiment, this embodiment can realize light emission in six directions, thus the light distribution is more even, and the light extraction can also be maximized.

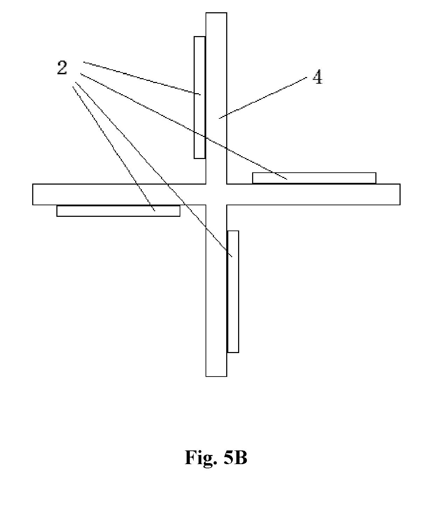

Figs. 5A and 5B schematically show the transparent bracket according to the third embodiment of the present invention. Different from the Y-shape configuration of the second embodiment, the transparent bracket of this embodiment comprises a cross-shape configuration formed of four planar branches. Preferably, the four planar branches are symmetrically distributed about the central axis, that is, the angle between two neighboring planar branches is preferably 90°, but other symmetric or asymmetric configurations are also possible.

As seen from the perspective view in Fig. 5A, one LED chip is bonded on each plane branch by a transparent glue, and two electrodes (i.e., the positive electrode and the negative electrode) are fixed on any two plane branches. For the purpose of simplification, the figure only shows the welding wires for electrical connection between the chip and the electrodes, the welding wires between chips in series are not shown. Of course, in order to weld conveniently, one LED chip and two electrodes (positive electrode and negative electrode), which connect to the positive terminal and negative terminal of the chip, respectively, can be positioned on each plane branch, thus in the susceptor (not shown), the positive and negative power supply lines are connected to four positive electrodes and four negative electrodes, respectively. Further, the transparent bracket shown in Fig. 1 can be used as one plane branch of the embodiment, that is, there are a plurality of LED chips in series on each plane branch.

As seen from the top view of Fig. 5B, each LED chip is positioned on the same side of each plane branch, the light emitted from the front face of each chip and those from the rear face of another chip which travels through the transparent material may complement each other, and the main light path perpendicular to the chip surface will not be sheltered by the neighboring chips. Therefore, similar to light emission in six direcrions in the second embodiment, this embodiment can realize uniform light emission in four directions, and the light extraction can also be maximized.

Although the present invention has been described in details in connection with the embodiments shown in the figures, it is to be understood by those skilled in the art that other embodiments will provide the same results. Variations and modifications to the present invention are obvious to those skilled in the art and in the scope of the present invention.

## Claims

1. A method for packaging an LED emitting light omnidirectionally, comprising:
bonding at least one LED chip and at least two electrodes to a transparent bracket with a transparent glue ;
generating an electrical connection between the LED chip and the electrodes with welding wires; and
vertically or slantingly, with an angle between 0 and 60, fixing the transparent bracket with the LED chip, the electrodes and the welding wires in a transparent vessel.

2. The method for packaging an LED according to Claim 1, wherein the transparent bracket is vertically or slantingly, with an angle between 0 and 60, arranged on a susceptor within the transparent vessel.

3. The method for packaging an LED according to Claim 2, wherein the vertical arrangement of the transparent bracket is realized by molding via the following steps:
positioning the transparent bracket and power supply lines into a mold, wherein the electrodes of the transparent bracket cling to the power supply lines; and
casting plastic material around a location where the electrodes and the power supply lines contact each other and curing the plastic material to form the susceptor.

4. The method for packaging an LED according to Claim 2, wherein the vertical arrangement of the transparent bracket is realized by clipping via the following steps:
fabricating power supply lines and the susceptor integrally, wherein one end of the power supply lines is embedded into the susceptor;
forming a groove in the central part of the susceptor to expose the power supply lines, wherein the groove is sized to be able to tightly clip the transparent bracket having electrodes; and
inserting the transparent bracket into the groove to form an electrical connection between the electrodes and the power supply lines.

5. The method for packaging an LED according to Claim 1, wherein the transparent bracket is vertically or slantingly, with an angle between 0 and 60, fixed by filling and curing a transparent material into the transparent vessel.

6. The method for packaging an LED according to Claim 1, further comprising filling an insulating transparent liquid into the transparent vessel.

7. The method for packaging an LED according to Claim 1, further comprising coating a fluorescent layer on the inner surface of the transparent vessel.

8. The method for packaging an LED according to Claim 1, wherein the transparent bracket is transparent glass or transparent organic film with a thickness of 0.4 mm to 5 mm.

9. The method for packaging an LED according to Claim 1, wherein the welding wires are gold or alloy conductive wires.

10. The method for packaging an LED according to Claim 1, wherein the transparent vessel is a circular or rectangular vessel.

11. The method for packaging an LED according to Claim 1, wherein the transparent bracket comprises a Y-shape assembly formed of three planar branches, and an angle between two neighboring planar branches is 120°.

12. The method for packaging an LED according to Claim 1, wherein the transparent bracket comprises a cross-shape assembly formed of four planar branches, and an angle between two neighboring planar branches is 90°.

13. An LED package emitting light omnidirectionally, comprising:
a transparent bracket;
at least one LED chip and at least two electrodes bonded to the transparent bracket via a transparent glue;
welding wires for connecting the LED chip and the electrodes; and
a transparent vessel;
wherein the transparent bracket bonded with the LED chip, the electrodes and the welding wires is vertically or slantingly, with an angle between 0 and 60, fixed in the transparent vessel.

14. The LED package according to Claim 13, further comprising a susceptor positioned in the transparent vessel.

15. The LED package according to Claim 14, wherein the transparent bracket is vertically or slantingly, with an angle between 0 and 60, arranged on the susceptor via molding or a clipping.

16. The LED package according to Claim 13, wherein the transparent bracket is vertically or slantingly, with an angle between 0 and 60, fixed by filling and curing a transparent material into the transparent vessel.

17. The LED package according to Claim 13, further comprising an insulating transparent liquid filled within the transparent vessel.

18. The LED package according to Claim 13, further comprising a fluorescent layer coated on an inner surface of the transparent vessel.

19. The LED package according to Claim 13, wherein the transparent bracket is a transparent glass or transparent organic film with a thickness of 0.4 mm to 5 mm.

20. The LED package according to Claim 13, wherein the welding wires are gold or alloy conductive wires.

21. The LED package according to Claim 13, wherein the transparent vessel is a circular or rectangular vessel.

22. The LED package according to Claim 13, wherein the transparent bracket comprises a Y-shape assembly formed of three planar branches, and an angle between two neighboring planar branches is 120°.

23. The LED package according to Claim 22, wherein the same number of LED chips are positioned on the same side of each plane branch.

24. The LED package according to Claim 13, wherein the transparent bracket is a cross-shape assembly formed of four planar branches, and an angle between two neighboring planar branches is 90°.

25. The LED package according to Claim 24, wherein the same number of LED chips are positioned on the same side of each plane branch.
